(19) Europäisches Patentamt
European Patent Office
Office européen des brevets

(11) **EP 4 462 698 A1**

(12) **EUROPEAN PATENT APPLICATION**

(43) Date of publication:
**13.11.2024 Bulletin 2024/46**

(21) Application number: **23219598.2**

(22) Date of filing: **22.12.2023**

(51) International Patent Classification (IPC):
***H04B 10/54*** (2013.01)   ***H04B 10/70*** (2013.01)
***H01S 5/00*** (2006.01)   ***H01S 5/0625*** (2006.01)

(52) Cooperative Patent Classification (CPC):
**H04B 10/54; H01S 5/0085; H01S 5/06216;
H01S 5/4006; H04B 10/70;** H01S 5/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.05.2023 GB 202307031**

(71) Applicant: **Kabushiki Kaisha Toshiba
Minato-ku
Tokyo (JP)**

(72) Inventors:
• **PARAISO, Taofiq
Cambridge, CB4 0GZ (GB)**
• **DU, Han
Cambridge, CB4 0GZ (GB)**
• **SHIELDS, Andrew James
Cambridge, CB4 0GZ (GB)**

(74) Representative: **Marks & Clerk LLP
15 Fetter Lane
London EC4A 1BW (GB)**

(54) **AN OPTICAL DEVICE**

(57)   An optical device comprises a light source, an intensity control element (adjustable between an on-state and an off-state), an optical channel, and an optical component. The light source supplies an optical pulse to the intensity control element, which modulates an intensity of the received pulse and to provides the modulated pulse to the channel. The intensity of the modulated pulse is higher when the intensity control element is in the on-state than in the off-state. The optical component receives the modulated pulse from the channel. The optical intensity modulator is configured such that at least a portion of the pulse is modulated in the on-state, the leading edge of said portion exits the intensity modulator at a first time, and the intensity modulator is in the off-state at a second time which is twice the propagation time measured from to the first time.

Figure 1

EP 4 462 698 A1

**Description**

Technical Field

Embodiments described herein relate to optical devices.

Background

In optical communication, it is frequently necessary to protect light sources, such as lasers, from back reflections. For example, a beam emitted by a laser may be partially reflected back to the laser by other optical components of an optical system. These back reflections can decrease the performance and stability of the laser since the back reflections can result in frequency or power changes of the light emitted by the laser or can otherwise damage the laser. For free-space optical systems, specific optical components - commonly referred to as optical isolators - can be used to protect lasers from unwanted back reflections. These optical isolators can be based on non-reciprocal optical elements and generally allow light propagation in one direction but block (or strongly attenuate) light propagation in the other direction.

One of the applications in which lasers with high stability are employed is in quantum communications systems. In a quantum communication system, information is sent between a transmitter and a receiver by encoded single quanta, such as single photons. Each photon carries one bit of information encoded upon a property of the photon, such as its polarization, phase or energy/time. A quantum communication system may be used to implement quantum key distribution (QKD) which is a technique for sharing of cryptographic keys between two parties; a transmitter, often referred to as "Alice", and a receiver, often referred to as "Bob". The attraction of this technique is that it provides a test of whether any part of the key can be known to an unauthorised eavesdropper, often referred to as "Eve".

In a quantum communication system, the transmitter "Alice" may employ two cascaded lasers to generate the desired quantum state of the light that is to be transmitted to "Bob", i.e. an arrangement where the light emitted by a first laser is injected into a second laser to control the emission of the second laser. In this case, it is frequently necessary to protect the first laser from light back reflected of the second laser as well as from light emitted by the second laser towards the first laser. To improve the scalability and cost efficiency and to reduce the overall dimensions of such a quantum communication transmitter, it is desirable to implement this device as a compact photonic integrated circuit. However, conventional optical isolators are not available for photonic integrated circuits since the non-reciprocal optical elements on which these isolators are based are not compatible with the fabrication techniques commonly used for photonic integrated circuits.

Brief Description of the Drawings

Embodiments will now be described with reference to the following figures:

Figure 1 is a schematic illustration of an example optical device in accordance with an embodiment;
Figure 2 shows five graphs illustrating an operation of the optical of the optical device of Figure 1;
Figure 3A is a schematic of a primary and secondary laser arrangement, Figure 2B is a plot of the optical frequency of the primary laser under a small perturbation of the control gain of duration $t_m$, Figure 3C is a plot of optical phase trajectories with and without the perturbation of the primary laser, and Figure 3D is a plot of the output pulses of the secondary laser;
Figure 4 is a schematic illustration of an example optical device in accordance with an embodiment, comprising a gain-switched laser;
Figure 5 shows six graphs illustrating an operation of the optical of the optical device of Figure 4;
Figure 6 is a schematic illustration of an example optical device in accordance with an embodiment, comprising a gain-switched laser and a beam splitter; and
Figure 7 shows six graphs illustrating an operation of the optical of the optical device of Figure 6.

Detailed Description

In an embodiment an optical device is provided. The optical device comprises a light source, an intensity control element being adjustable between an on-state and an off-state, an optical channel comprising a first and a second port and an optical component. The optical channel is characterised by an optical propagation time through the optical channel (i.e. from the first to the second port). The light source is configured to supply an optical pulse to the intensity control element. The intensity control element is configured to modulate an intensity of the received optical pulse and to provide the modulated pulse to the first port of the optical channel. An intensity of the modulated optical pulse is higher when the intensity control element is in the on-state than in the off-state. The optical component is configured to receive the modulated optical pulse from the second port of the channel. The optical intensity modulator is configured such that at least a portion of the optical pulse is modulated in the on-state, the leading edge of said portion exits the optical intensity modulator at a first time, and the optical intensity modulator is in the off-state at a second time which is twice the propagation time measured from to the first time.

The disclosed system provides an improvement to optical devices by protecting the light source of the device from backward propagating light from the second port of the optical channel (e.g. unwanted back reflections arising from the light emitted by the laser). Specifically, the disclosed system provides for an intensity controlling element (e.g. an intensity modulator) which (periodically) modulates the optical intensity of light propagating between the light source and an optical component (the optical component may be partially reflecting, for example a passive element or an active light emitting/amplifying element). For example, the intensity controlling element alternates between "on" and "off" states which allow/block (or which amplify/not amplify if the intensity controlling element is an optical amplifier or the like) light propagation between the light source and the optical component. Further, the disclosed system provides an optical channel between the intensity controlling element and the optical component which acts a delay line sufficiently delaying the arrival time of any light back reflected (or emitted) by the optical component. Thus, the intensity controlling element can modulate the intensity of the backward propagating light to prevent this light from disturbing the light source. For example, the intensity controlling element can be operated such that, during a time period when a reflection from the optical component is impinging back upon the intensity controlling element, the intensity controlling element is set to "off", i.e. blocking or (at least) strongly attenuating (or not-amplifying if the intensity controlling element is an optical amplifier) the transmission through the intensity controlling element. In this way the reflected light is either completely prevented from propagating back to the light source or is at least sufficiently low in intensity such that the performance of the light source is not substantially affected.

One way of implementing this is for the disclosed system to be configured such that the timings of the "on" and "off" periods are set according to a roundtrip time between the between the light source and the optical component (i.e. the time needed for light emitted from the light source to propagate from the intensity controlling element to the optical component and back to the intensity controlling element). In the disclosed system, the roundtrip time corresponds to twice the propagation time through the optical channel that connects the intensity controlling element to the optical component. For example, when an optical pulse exits the intensity controlling element in the "on"-state at a first time, then the intensity controlling element may be switched to be in the "off"-state at a second time which is later than the first time by the roundtrip time (thus any light reflected or generated by the optical component in response to receiving the modulated pulse is blocked by the intensity controlling element). The disclosed system may improve the stability of the light source and may be useful for a range of applications, for example by enabling fully integrated, compact optical transceivers for use in coherent optical communications or in quantum communication. Such a fully integrated, compact optical transceiver is preferable over conventional systems comprised of discrete, off-chip components since fully integrated, transceiver can have a much smaller footprint, lower cost and higher manufacturing yield.

In an embodiment, the device may further comprise a semiconductor substrate. The light source, the intensity control element, the optical channel and the optical component may be integrated on the semiconductor substrate.

In an embodiment, the intensity of the modulated optical pulse may be at least twice as high when the intensity control element is in the on-state than in the off-state.

In an embodiment, the on-state may be held for a first duration which is equal to or shorter than twice the propagation time through the optical channel. Additionally, the off-state may be held for a second duration. The second duration may be equal or longer than twice the propagation time through the optical channel. Further in this embodiment, the second duration may equal to the first duration, and the first duration may equal to twice the propagation time through the optical channel. Additionally or alternatively, the optical pulse may have a pulse duration which is longer than the first duration.

In an embodiment, the device may further comprise a light source controller configured to control to the light source, and an intensity control element controller configured to control the intensity control element to switch the intensity control element between the on-state and the off-state. Additionally, the device may be further configured to receive information specifying the first and second durations, and the intensity control element controller may be further configured to hold and switch the state of the intensity control element based on the received information.

In an embodiment, the optical component may be at least partially reflective.

In an embodiment, the optical component may be an optical grating, a multimode interferometer, a mirror, a scattering element, or a photonic nanostructure.

In an embodiment, the light source may be configured to supply coherent light to the intensity control element. Further in this embodiment, the light source may be configured to supply light pulses to the intensity control element with a pulse repetition period equal to a sum of the first duration and a second duration. For each pulse, the on-state may be held for a first duration and the off-state may be held for the second duration. A phase difference between consecutive pulses may be random.

In an embodiment, the light source may be a first light source, and the optical component may be a second light source configured to produce optical amplification. The device may further comprise a second light source controller configured to apply a time varying signal to the second light source such that a plurality of light pulses, having a fixed phase relation, are emitted from the second light source during a period of time that coherent light transmitted through the intensity control element during the first duration is received.

In the above, the device may further comprise an encoder configured to encode information in an emission time of the plurality of light pulses emitted from the second light source during a period of time that coherent light transmitted through the intensity control element during the first duration of time is received. Alternatively, the device may further comprise an encoder configured to encode information in a phase difference between the plurality of light pulses emitted from the second light source during a period of time that coherent light transmitted through the intensity control element during the first duration is received.

In an embodiment, the second light source may comprise at least one of an optical gain medium, a laser cavity and an optical resonator.

In an embodiment, the intensity control element may comprise at least one of an electro-absorption modulator, a Mach-Zehnder modulator, a semiconductor optical amplifier or an optical switch.

In an embodiment, the first light source may comprise a semiconductor laser diode.

In an embodiment, the semiconductor laser diode may be a distributed feedback laser.

In an embodiment, the semiconductor laser diode may a stripe laser.

In an embodiment, the semiconductor laser diode may be a vertical cavity surface emitting laser.

In an embodiment, the optical channel may comprise a beam splitter. The beam splitter may be configured to receive, at a first port of the beam splitter, the coherent light transmitted through the intensity control element and provide, at a second port of the beam splitter, at least a portion of the received coherent light to the second light source. The second light source may be configured to receive, from the second port of the beam splitter, the at least portion of the coherent light and to provide the plurality of generated light pulses to the second port of the beam splitter. The optical device may further comprise an output port configured to provide, as output, at least a portion of the plurality of generated light pulses received from a third port of the beam splitter.

In an embodiment, a transmitter for a quantum communication system is provided. The transmitter may comprise the optical device.

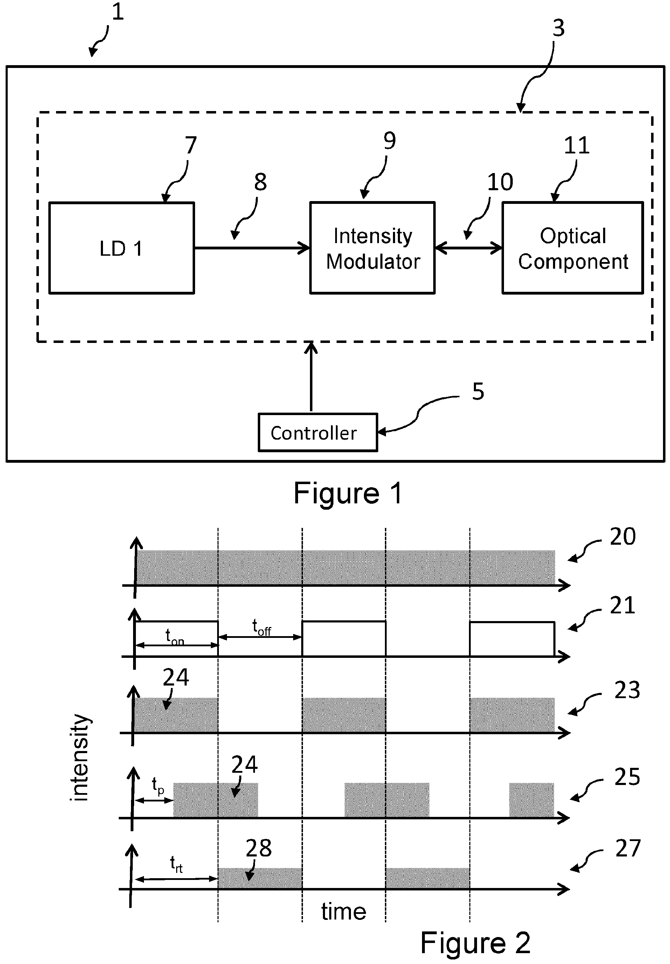

Further embodiments will now be described by way of example. An example optical device 1 is illustrated Figure 1. The optical device 1 comprises a photonic integrated circuit (PIC) 3 and a controller 5. The PIC 3 may comprise a semiconductor substrate, and components included in the PIC 3 may be integrated on the semiconductor substrate.

In an embodiment, the PIC 3 may be formed of InP. The components included in the PIC 3, as described in detail below, and any ports for providing optical signals may be formed together. To this end, patterns may be defined by photolithography and/or e-beam lithography, and corresponding structures may be formed by plasma dry etching methods. For example, reactive-ion etching (RIE) methods, such as inductively coupled plasma (ICP) RIE and deep reactive ion etching (DRIE), may be used to form the structures. Optical waveguides to connect the components integrated in the PIC 3 may be formed using (optical and/or electron) lithography, (plasma and/or chemical) etching, direct laser writing, ion exchange, nanoimprint, and the like. In other embodiments, the PIC 3 may be formed of another suitable semiconductor material system, for example Si, SOI, SiN, SiO2, SiON, or GaAs. Alternatively, the PIC 3 may be formed of glasses or polymers. Hybrid integration and heterogeneous integration techniques can be used to form the PIC 3 using more than one of material system.

The PIC 3 comprises a light source 7, an intensity modulator 9, and an optical component 11. In general, the light source 7 may be a coherent light source or a non-coherent light source. A coherent light source emits light that can be coherent (with waves maintaining a fixed and predictable phase relationship over a period of time). A non-coherent light source emits light that can be non-coherent (with amplitude and/or phase characteristics that fluctuate randomly in space and time).

In an embodiment, the light source 7 may be configured to generate coherent light and to supply the generated coherent light to the intensity modulator 9. For example, the light source 7 may provide the coherent light to an optical channel 8 (such as a waveguide) that allows light propagation between the light source 7 and the intensity modulator 9. The light source 7 may be operated to emit a continuous wave or to emit optical pulses of a predetermined duration.

In an embodiment, the light source 7 is a (gain-switched) semiconductor laser diode. The semiconductor laser diode may be a distributed feedback (DFB) laser, a vertical cavity surface emitting laser or a ridge laser. Ridge lasers are also referred to as stripe lasers. A Fabry-Perot laser is a type of ridge or stripe laser. The terms stripe and ridge refer to the form of the laser waveguide. Fabry Perot refers to the form of the laser cavity i.e. two parallel mirrors made up by the end faces of the waveguide. In an embodiment, the light source 7 may emit coherent light at a telecom wavelength.

The intensity modulator 9 is configured to modulate (or control) the intensity of light that propagates between the light source 7 and the optical component 11. Generally, the intensity modulator 9 is configured to be adjustable between at least two states, a high intensity state (referred to as "on"-state) and a low intensity state (referred to as "off"-state). For example, the intensity of an optical pulse that passed the intensity modulator 9 in the "on"-state may be at least twice as high as the corresponding intensity after passing through the intensity modulator 9 in the "off"-state. The intensity modulator 9 may further be configured to be periodically switched (e.g. by the controller 5) between the "on"-and "off"-state. In an embodiment, "on" and "off" durations (or switching timings) may be set during the manufacturing process of device 1 (e.g. hard wired into the circuitry of the controller 5). Alternatively, the "on" and "off" durations (or switching timings) may be adjustable (e.g. they can be changed based on the requirements of a specific application). For example, the device 1 may be configured to receive information specifying the "on" and "of" durations (or switching timings) and controller 5 may be configured to control the intensity modulator 9 based on the received instructions.

The intensity modulator 9 is typically bidirectional, i.e. in a given state (e.g. "on" or "off"), light is being modulated by the intensity modulator 9 in the same way whether the light is received from the light source 7 or from the optical component. In an embodiment, the intensity modulation performed by the intensity modulator 9 may be continuously tuneable.

The intensity modulator 9 may be implemented in a number of ways. For examples, the intensity modulator 9 may apply a state-dependent optical attenuation (i.e. a stronger attenuation in the "off"-state than in the "on"-state). Alternatively, the intensity modulator 9 may apply a state-dependent optical amplification (i.e. a stronger optical amplification in the "on"-state than in the "off"-state). The intensity modulator 9 may, for example, comprise one or more of an electro-absorption modulator, a Mach-Zehnder modulator, a semiconductor optical amplifier or an optical switch. An electro-absorption modulator may be particularly suitable for integration on a photonic integrated circuit. A Mach-Zehnder modulator may be particularly suitable for high-speed applications. An optical switch (e.g. based on MEMS technology) may be used to completely block the optical path between the light source 7 and the optical component 11 in the "off"-state.

The optical component 11 is configured to receive the coherent light transmitted through the intensity modulator 9. For example, an optical channel 10 (such as a waveguide) between the intensity modulator 9 and the optical component 11 enables light propagation between these two components. In an embodiment, the optical component 11 may be at least partially reflective, i.e. the optical component 11 may reflect (a portion of) the coherent light received from the intensity modulator 9 such that the reflected light propagates back towards the intensity modulator 9. The optical component 11 may be an optical grating, a multimode interferometer, a mirror, a scattering element, or a photonic nanostructure.

A period of time that the light emitted by the light source 7 needs to propagate through the optical channel 10, i.e. from the intensity modulator 9 to the optical component 11, is referred to as optical propagation time $t_p$. Similarly, a period of time that the light emitted by the light source 7 needs to propagate from the intensity modulator 9 to the optical component 11 and back to the intensity modulator 9 is referred to as optical roundtrip time $t_{rt}$. The roundtrip time $t_{rt}$ may be twice the propagation time $t_p$. In embodiments, the optical propagation time $t_p$ is 500ps or less, 250ps or less, or 100ps or less. In broad terms, the optical channel 10 acts a delay line which sufficiently delays the arrival time of any light back reflected by the optical component 11 so that the intensity modulator can modulate the intensity of the backward propagating light to prevent this light causing negative effects for the light source 7.

The controller 5 of the optical device 1 is configured to control (the operation of) the light source 7 and the intensity modulator 9. To this end, the controller 5 may apply (time varying) electrical signals to the light source 7 and intensity modulator 9 such that the light source 7 is protected from back reflections caused by the optical component 11, for example as described below with reference to Figure 2. The controller 5 may comprise electrical circuitry to generate and apply appropriate electrical signals for controlling the light source 7 and the intensity modulator 9. In an embodiment, the controller 5 may be fully or partially integrated in the PIC 3.

With reference to Figure 2, an example operation of the optical device 1 of Figure 1 is described. For brevity, we use the term "forward propagating" for light propagating from the light source 7 towards the optical element 11, and the term "backward propagating" for light propagating from the optical element 11 towards the light source 7. In this example, the light source 7 may be operated in a continuous-wave operation, i.e. the light source 7 may emit coherent light with a constant intensity, as illustrated in graph 20 of Figure 2. The intensity modulator 9 may be periodically switched between the "on"- and "off"-state. In this example, intensity modulator 9 is assumed to completely block light propagation in the "off"-state and allow light transmission in the "on"-state. Graph 21 shows a signal applied to the intensity modulator 9 to control its state. Initially, the intensity modulator 9 is set into the "on"-state for a period of time $t_{on}$. Then, the intensity modulator 9 is set into the "off"-state for a period of time $t_{off}$, before being switched back to the "on"-state for another period $t_{on}$ and so on. Graph 23 shows the intensity of the forward propagating light after being modulated by the intensity modulator 9. Due to the switching of the states of the intensity modulator 9, the constant intensity output of the light source is modified by the intensity modulators into pulses with a pulse length $t_{on}$, such as the example pulse 24 as indicated in Figure 2.

Graph 25 of Figure 2 shows the intensity of the coherent light received by the optical component 11. As shown in graph 25, the intensity received by the optical component 11 is low for an initial period of time that is equal to the propagation time $t_p$, since this time is needed for the light to travel through the optical channel 10, i.e. from the intensity modulator 9 to the optical component 11. From time $t = t_p$, the example pulse 24 impinges upon the optical component 11 for a period $t_{on}$. During this time, the optical component may (partially) reflect the incoming pulse 24 back towards the intensity modulator (and the light source 7). Graph 27 shows the intensity of the backward propagating light received by the intensity modulator 9 from the optical component 11. In graph 27, the (partial) reflection of pulse 24 is indicated as reflected pulse 28. As shown in graph 27, from time $t = t_{rt}$, the backward propagating pulse 28 impinges upon the intensity modulator for a period $t_{on}$. In the example of Figure 2, the optical device 1 is configured and operated such that the periods for the "on"-state, the "off"-state and the roundtrip time $t_{rt}$ are equal ($t_{on} = t_{off} = t_{rt}$). This means that the light reflected by the optical component 11 (e.g. the reflected pulse 28) only impinges upon the intensity modulator 11 when the intensity modulator 11 is in the off-state. This means that the reflected light is blocked (or strongly attenuated) by the intensity modulator 11 and effectively prevented from propagating back to the coherent light source 7.

In the example of Figure 2, the periods for the "on"-state, the "off"-state and the roundtrip time $t_{rt}$ are all equal ($t_{on} = t_{off} = t_{rt}$). In other embodiments, the period for the "on"-state may be equal or shorter than the roundtrip time (i.e. $t_{on} \le t_{rt}$), and the period for the "off"-state may be equal or longer than the roundtrip time (i.e. $t_{rt} \le t_{off}$).

Thus, in broad terms, the optical device 1 employs active, time-dependent transmission modulation to protect the coherent light source 7 from unwanted back reflections. By blocking (or attenuating) back reflections, formation of an effective cavity between the light source 7 and the optical element 11 is suppressed and the creation of unwanted side-modes associated with such cavities is prevented, resulting in an improved operation of the light source 7. This active, time-dependent transmission modulation is compatible with photonic integration and thus enables reflection-protection in fully integrated devices.

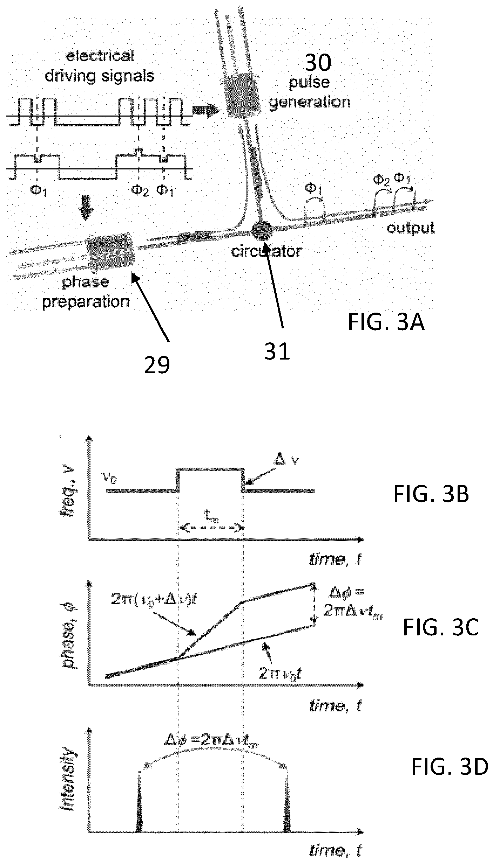

It is frequently desirable, for example to implement certain QKD protocols, to generate and output pairs (or larger numbers of) of short laser pulses emitted with a controlled time delay between the light pulses in each pair. It is further desirable to control the phase difference between the pulses of a pulse pair. To this end, a phase-seeding technique may be used. In general, phase-seeding is an information encoding technique that employs gain switching, direct modulation and optical injection locking between two cascaded lasers to encode arbitrary phase states. A phase-seeding technique is described below with reference to Figures 3A-D.

Referring to Figure 3A, a pulse from a primary laser 30 is injected into a pulsed secondary laser 30 to define the phase between the secondary laser's output pulses, based on optical injection locking. The primary laser 29 performs the task of phase preparation whereas the secondary laser 30 performs the task of pulse preparation. As schematically depicted in Figure 3A, a primary laser diode 29 is connected to a secondary laser diode 30 via an optical circulator 31. It should be noted that the primary 29 and secondary 30 laser diodes may be identical, the terms "primary" and "secondary" are used merely for clarity and do not imply any physical differences between the primary 29 and secondary 30 laser diodes.

The primary laser 29 is used for phase-preparation is directly modulated to produce long pulses from quasi-steady-state emission. Each of these pulses coherently seeds a block of two or more secondary, short optical pulses emitted by gain switching the secondary or pulse-generation laser 30. The phase-preparation laser 29 is biased to produce nanosecond scale or even less, quasi-steady-state optical pulses with shallow intensity modulation, which also modifies the optical phase. For clock rates greater than 1 GHz, the pulse width is less than 1 ns. The gain-switched pulse-generation laser 30 emits short optical pulses which inherit the optical phase prepared by the phase-preparation laser. The duration of each phase-preparation laser pulse can be varied to seed a pulse train of different lengths.

The relative phase between the secondary pulses depends on the phase evolution of the primary pulses and can be set to an arbitrary value by directly modulating the driving current applied to the primary or phase-preparation laser 29.

For example, a relative phase $\phi_1$ between two secondary pulses can be obtained by introducing a small perturbation in the driving signal of the phase-preparation laser 29. Similarly, the relative phases between three secondary pulses can be set to $\phi_1$ and $\phi_2$ by adding two small perturbations to the driving signal of the primary laser 29.

In principle, such perturbations in the driving signal would cause detrimental fluctuations in the intensity and frequency of the primary pulses. However, these can be avoided by switching the secondary laser's 30 gain off in correspondence with the perturbation signals. Effectively, the secondary laser 30 also acts as a filter rejecting residual modulations.

To understand how an optical phase is set by perturbing the driving signal applied to the phase-preparation laser, it is useful to consider a continuous wave laser above threshold emitting at the central frequency $\upsilon_0$.

Figure 3B is a plot of the optical frequency of the phase-preparation laser under a small perturbation of duration $t_m$. Figure 3C is a plot of optical phase trajectories with and without the perturbation of the phase-preparation laser.

When a small perturbation is applied to the driving signal, the optical frequency shifts by an amount $\Delta\upsilon$, changing the course of the phase evolution. When the perturbation is switched off, the frequency is restored to the initial value $\upsilon_0$. This perturbation will create a phase difference:

$$\Delta\phi = 2\pi\Delta\upsilon t_m$$

where $t_m$ is the duration of the perturbation. Through optical injection, this phase difference is transferred onto a pair of secondary pulses emitted by the pulse-generation laser as shown in Figure 3D.

The perturbation signal here is an electrical voltage modulation applied to the phase-preparation laser. The optical frequency change arises from the effect of the carrier density on the refractive index in the laser active medium within the primary laser diode 29. The laser cavity confinement allows the light field to oscillate back and forth within the cavity and experience the refractive-index change for the entire duration of the perturbation. The enhancement due to the laser cavity makes it possible to keep the phase modulation half-wave voltage below 1 V. This cavity feature is absent in conventional phase modulators, where the light makes just a single pass across the electro-optic medium, thus limiting the interaction distance to the device length.

Small changes to the primary light source's electric controller signal (of less than 1 volt - much less than required by a conventional lithium niobite phase modulator) can yield transient changes to the output frequency of the primary light source's output, which then change the output phase of the secondary laser's optical output.

In this embodiment, the primary laser 29 is configured to output a sequence of light pulses comprises a sequence of pairs. The phase of the pulses output by the primary laser is controlled so that the phase between pulses in the same pair is randomly selected from one of a set of phase differences and there is a random phase difference between pulses from different pairs. In an embodiment, the set of phase differences may be selected from one of 0, $\pi/2$, $-\pi/2$ and $\pi$.

The secondary laser 30 that is seeded by the primary laser 29 will output a sequence of pairs of pulses having the same phase differences as the sequence of pulses output by the primary laser 29.

Pulsed injection seeding occurs each time the secondary laser 30 is switched above the lasing threshold. In this case, the generated slave light pulse has a fixed phase relation to the injected master light pulse. When only one secondary light pulse is generated for each injected master light pulse, the phase relationship between the pulses output by the secondary laser 30 is the same as the relationship between the pulses injected into the secondary laser 30.

The secondary laser 30 is typically operated to generate a new sequence of pulses, which comprise a sequence of pairs. The phase between pulses in the same pair is randomly selected from one of a set of phase differences and there is a random phase difference between pulses from different pairs. These pulses will also have a smaller time jitter $\tau' < \tau$ to the pulses outputted by the primary laser 29. The reduced jitter time this improves interference visibility due to the low time jitter of the secondary light pulses.

In order for pulsed injection seeding to occur, the frequency of the light pulses from the primary laser 29 must match the frequency of the secondary laser 30 to within a certain range. In one embodiment, the difference in the frequency of the light supplied by the primary laser 29 and the frequency of the secondary laser 30 is less than 30GHz. In some embodiments, where the secondary laser 30 is a distributed feedback (DFB) laser diode the frequency difference is less than 100GHz.

For successful pulsed injection seeding the relative power of the primary laser 29 output light pulses that enter the optical cavity of the secondary laser 30 has to be within certain limits which depend on the type of light source that is used. In one embodiment, the optical power of the injected light pulses is at least 1000 times lower than the optical output power of the secondary laser 30. In one embodiment, the optical power of the injected light pulses is at least 100 times lower than the optical output power of the secondary laser 30.

In one embodiment, secondary laser 30 and primary laser 29 are electrically driven, gain-switched semiconductor laser diodes. In one embodiment, the slave light source and master light source have the same bandwidth. In one embodiment, both light sources have a bandwidth of 10 GHz. In one embodiment, both light sources have a bandwidth of 2.5 GHz. Here, the bandwidth means the highest bit rate achievable with the gain-switched laser diode under direct modulation. A laser of a certain bandwidth can be operated at a lower clock rate.

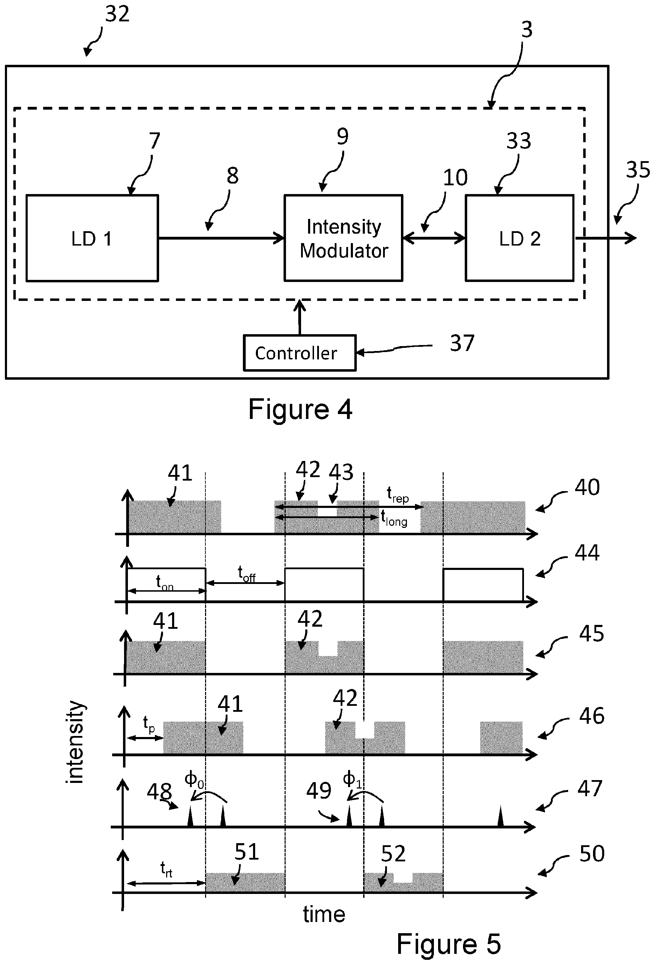

Figure 4 shows a variation on the optical device of Figure 1 suitable for implementing phase seeding techniques like the one described above (to avoid unnecessary repetition, like reference numerals will be used to denote like features).

In broad terms, the optical device 32 of Figure 4 is a fully integrated optical transceiver for a wide range of applications, for example in coherent optical communications and quantum communication systems. In particular, the optical device 32 may be used to implement QKD protocols. As described below, the optical device 32 can output pairs of short laser pulses (or triplets, or other groups of pulses) emitted with a controlled time delay between the light pulses in each pair. Further, the optical device 32 provide control of the phase difference between the pulses of a pulse pair (or triplet or other group of pulses) by employing the phase-seeding technique described above.

The optical device 32 comprises a PIC 3 with the light source 7 (referred to as first light source from hereon) and the intensity modulator 9, as described with reference to Figure 1. The first light source 7 of Figure 4 is coherent light source. Further, the optical device 32 comprises a second light 33 (as an embodiment of the optical component 11 of Figure 1). The first light source 7 is configured to generate long coherent light pulses. A time period $t_{rep}$ denotes a pulse repetition period of the generated long light pulses. Where the first light source 7 is a semiconductor gain-switched laser, controller 37 of the optical device 32 includes a circuit that applies a time varying current such that the first light source 7 is switched periodically above the lasing threshold, generating long light pulses. The current applied to the first light source 7 has the form of a series of current modulation pulses. The current may not be reduced to zero in between the current modulation pulses, but only to a bias value.

In embodiments, the duration $t_{long}$ of each of the long light pulses is greater than or equal to 600ps, greater than or equal to 300ps, greater than or equal to 200ps, or greater than or equal to 100ps.

The long light pulses emitted from first light source 7 are provided the optical channel 8 to the intensity modulator 9 which is configured to control an optical transmission between the first light source 7 and the second light source 33. As described with reference to Figure 1, the intensity modulator 9 is configured to be periodically switched (e.g. by the controller 37) between the "on"-state and the "off"-state. The switching of the intensity modulator 9 can be synchronised with the arrival of the long light pulses. For example, a time varying signal applied to the first light source 7 in order to generate long light pulses and the time varying signal applied to the intensity modulator 9 in order to between the "on"-state and the "off"-state can be synchronised to a master clock. In embodiments, the optical device 32 may comprise the maser clock. In other embodiments, the optical device 32 is configured to receive clock signals from an external master clock.

In an embodiment, the switching of the intensity modulator 9 is synchronised to the generation of the long light pulses such that (i) at least a portion of each long pulse is transmitted through the intensity modulator 9 in the "on-state, and (ii) a sum of the periods for the "on" and "off"-states is equal to the repetition period of the long pulse, i.e. $t_{on} + t_{off} = t_{rep}$.

In the embodiment of Figure 4, the second light source 33 is a gain-switched laser and configured to receive the coherent light transmitted from the first light source 7 through the intensity modulator 9. For example, the intensity modulator 9 and the second light source 33 may be connected via a waveguide.

In other embodiments, the second light source 33 may be any suitable type of light source configured to produce optical amplification. For example, in these embodiments, the second light source 33 may comprise at least one of an optical gain medium, a laser cavity and an optical resonator.

Referring back to Figure 4, a portion of the coherent light received by the second light source 33 (via the optical channel 10) is injected into the second light source 33, i.e. a portion of the received coherent light enters (an optical cavity of) the second light source 33 and causes coherence seeding of the second light source 33.

In the embodiment of Figure 4, the controller 37 is configured to apply a time varying current to the second light source 33 such that this gain-switched laser is switched above the lasing threshold twice during the time that a long light pulse (emitted by the first light source 7) is incident on the second light source 33, generating two short light pulses. The switching of the second light source 33 can be synchronised with the arrival of the long light pulses. For example, a time varying signal applied to the first light source 7 in order to generate long light pulses and the time varying signal applied to the second light source 33 in order to generate short light pulses can be synchronised to the master clock.

In an embodiment, the second light source 33 is switched above the lasing threshold more than twice during the time that a long light pulse (emitted by the first light source 7) is incident on the second light source 33, thus generating more than two short light pulses (e.g. a triplet of short pulses).

In an embodiment, the controller 37 (or an encoder included in the optical device 32) may be further configured to encode information in an emission time of two (or more) short pulses emitted from the second light source during a period of time that coherent light transmitted through the intensity modulator 9 during the first period of time is received.

In order to switch the second light source 33 above the lasing threshold, the controller 37 may supply the time varying current to an AC input of a bias-T connected to the second light source 33. A DC bias current may be supplied to a DC input. In one embodiment, the time varying current has a square type wave form, for example with a frequency of 2 GHz. In an alternative embodiment, the time varying current is an electrical sine wave generated by a frequency synthesizer. The time varying current can comprise signals with arbitrary pulse shape.

The second light source 33 may be further configured to provide the short pulses (generated during the time that a long light pulse from the first light source 7 is incident on the second light source 33) to an output port 35 of the optical device 32. For example, the optical device 1 may be configured such that the output of the second light source 33 may be coupled into a tapered lensed fibre using a spot-size converter. For example, the short pulses provided at the output port 35 may be submitted via an optical (quantum) channel to a receiver.

In general, the second light source 33 can be used to generate very short pulses. In one embodiment, the duration of each of the short light pulses is less than 200ps. In one embodiment, the duration of each of the short light pulses is less than 50ps. In one embodiment, the duration of each of the short light pulses is of is less than 10ps. In one embodiment, where the time varying current is a square wave current with a frequency of 2 GHz, the short light pulses are 500ps apart.

In general, during operation of the second light source 33 without injection of light from first light source 7 (i.e. without coherence seeding), when the second light source 33 is switched above the lasing threshold a light pulse is initiated by spontaneous emission, and the phase difference between the generated light pulses is random. When the light from first light source 7 is injected into the second light source 33 and the second light source 33 is switched above the lasing threshold, a pulse is initiated by stimulated emission caused by the injected coherent light. This is referred to as coherence seeding. In order for coherence seeding to occur, the frequency of the injected light must match the frequency of the second light source 33 to within a certain range. In one embodiment, the difference in the frequency of the light supplied by the first light source 7 and the frequency of the second light source 33 is less than 30GHz. In some embodiments, where the second light source 33 is a distributed feedback (DFB) laser diode the frequency difference is less than 100GHz. In other embodiments, where the second light source 33 is a Fabry-Perot laser diode, the frequency difference is less than 3 Terahertz.

In an embodiment, the frequencies of the first and second light source 7, 33 may be tuned into resonance (or sufficiently close) using heater elements integrated on the PIC 3. The controller 33 may control the heater elements accordingly.

As described below, the optical device 33 can be operated to control the phase difference between the short pulses (generated during the time that a long light pulse from the first light source 7 is incident on the second light source 33). Further, the optical device can be operated such that the phase difference of short pulses generated during different long pulses is random.

When coherence seeding occurs, each time the second light source 33 is switched above the lasing threshold, the generated light pulse has a fixed phase relation to the injected coherent light. In one embodiment, the second light source 33 is switched above the lasing threshold twice during the time that each long light pulse is incident, therefore two coherent short light pulses with the same difference between the emission time of each pulse are generated each time a long light pulse is incident. The two short light pulses can be collectively referred to as a coherent double pulse. For example, a first pair of light pulses (pulse 1 and pulse 2) is generated during a period when a first long light pulse is incident. Pulses generated during a period when one long light pulse is incident are referred to as intra-period. A second pair of light pulses (pulse 3 and pulse 4) is generated when a second long light pulse is incident and a third pair of pulses (pulse 5 and pulse 6) is generated when a third long light pulse is incident. Pulse 1 and pulse 2 are intra-period. Pulse 3 and pulse 4 are intra-period. Pulse 5 and pulse 6 are intra-period. The first pair of pulses, second pair of pulses and third pair of pulses have a fixed phase relation, in other words the relative phase of the pairs is the same for each pair. The phase difference between pulse 1 and pulse 2 is the same as the phase difference between pulse 3 and pulse 4 and the phase difference between pulse 5 and pulse 6. In other words, the phase difference between any two consecutive intra-period pulses is the same for all periods.

Pulses generated during periods when different long light pulses were incident are referred to as inter-period. For example, pulse 1 and pulse 3 are inter-period, pulse 2 and pulse 3 are inter-period, pulse 4 and pulse 5 are inter-period, pulse 1 and pulse 6 are inter-period. The phase difference between two inter-period pulses (pulse 2 and pulse 3 for example) is not fixed, and is random. For example, the phase difference between pulse 2 and pulse 3 has a random relationship to the phase difference between pulse 4 and pulse 5. In a quantum communication system, this means that an unauthorised eavesdropper, Eve, cannot lock her measuring apparatus to this phase and thus perform a better measurement of Alice's pulses.

The phase difference between two consecutive inter-period pulses is only truly random if there is no phase coherence between consecutive long light pulses generated by the first light source 7. For a first light source 7 such as a semiconductor gain-switched laser, the laser emission is started by spontaneous emission. This is a random process, which means that the phase of the generated long light pulse will be random. In order that the random process of spontaneous emission is responsible for starting the laser emission for all long light pulses, the laser cavity needs to be completely empty before each long light pulse is generated, i.e. the applied current needs to be below the threshold current for a sufficiently long time in between long pulses.

For successful coherence seeding the fraction of the coherent light that is injected into the second light source 33 has to be within certain limits which depend on the type of gain-switched laser that is used. The intensity modulator 9 may be configured such that the transmission during the "on"-state results in an intensity of the long pulses that allows successful coherence seeding of the second light source 33. In one embodiment, the optical power of the injected coherent light is at least 1000 times lower than the optical output power of the second light source 33. In one embodiment, the optical power of the injected coherent light is at least 100 times lower than the optical output power of the second light source 33.

The phase difference between intra-period pulses can be controlled by controlling the phase of the light generated by the first light source 7. For any particular long light pulse generated by the first light source 7, the phase of a second part of this light pulse may be modulated with respect to a first part of the light pulse by applying a short current pulse to the first light source 7 (e.g. using the controller 33 or an encoder optionally included in the optical device 32) during the time that the coherent light is generated. Thus, the controller 33 (or the encoder) may be configured to modulate the first light source 7 to encode information in a phase difference between the short pulses light pulses emitted from the second light source during a period of time that coherent light from the first light source 7 is received.

The phase change between adjacent parts of the coherent light pulse may not be an abrupt transition, but may occur over a portion of the light. The second light source 33 is controlled such that short light pulses are not generated when a transition portion of the long light pulse is present in the second light source 33. For example, where the second light source 33 is configured to generate pairs of short pulses for each incoming long pulse, the first short pulse may be generated during the first part of the long pulse and the second short pulse may be generated in the second part of the long pulse (but no short pulse is generated during the transition period when the short current pulse is applied).

In an example operation of the optical device 32 is described with reference to Figure 4. In this example, the first light source 7 is operated to emit a number of long pulses. Graph 40 of Figure 4 illustrates the intensity of the long pulses emitted by the first light source 7 as received by the intensity modulator (but before the modulation is applied). In graph 40, two example pulses 41, 42 are indicated. Example pulse 41 has a constant intensity throughout its pulse duration. Example pulse 42 has a portion 43 of lower intensity. This portion 43 corresponds to the application of a short current pulse to the tailor the phase difference between a pair of short pulses which are generated by the second light source 33 during a time when pulse 42 is injected into the second light source 33. As described above, the intensity modulator 9 is periodically switched between the "on"- and "off"-state. Graph 41 shows a signal applied to the intensity modulator 9 to control its state. Initially, the intensity modulator 9 is set into the "on"-state for a period of time $t_{on}$. Then, the intensity modulator 9 is set into the "off"-state for a period of time $t_{off}$, before being switched back to the "on"-state for another period $t_{on}$ and so on. The first light source 7 and the intensity modulator 9 are synchronised in a way that a substantial portion of each of the long pulses is transmitted through the intensity modulator 9 during an "on" period. Graph 45 shows the intensity of the forward propagating light pulses after being modulated by the intensity modulator 9. In this example, duration $t_{long}$ of each of the long light pulses is longer than the "on" period of the intensity modulator 9. In the example of Figure 4, a front and an end portion of each long pulse is blocked from propagating to the second light source 33 (e.g. see example pulse 42 in graph 45). In an embodiment, blocking the front portion of the long pulses may result in an improved coherence seeding of the second light source 33 because each long pulse may exhibit a frequency chirp at the front of the pulse due to the change of the index of refraction inside the laser cavity related to the changing carrier density.

Graph 46 of Figure 4 shows the intensity of the coherent light received by the second light source 33. As shown in graph 46, the long pulses 41, 42 arrive at the second light source 33 with a delay equal to the propagation time $t_p$, since this time is needed for the light to travel from the intensity modulator 9 to the second light source 33. For example, from time $t = t_p$, the example pulse 41 impinges upon the second light source 33 for a period $t_{on}$. During this time, a portion of the received light may be injected into the second light source 33 and may result in phase seeding of the second light source 33. Another portion of the received light may be reflected back towards the intensity modulator (and the first light source 7). During the time that the long pulses (e.g. pulses 41, 42) are injected into the second light source 33, the controller 37 may apply a time varying current to the second light source 33 such that this gain-switched laser is switched above the lasing threshold twice, generating two short light pulses.

Graph 47 shows the short pulses emitted by the second light source 33 to the output port 37. The two pulses of the pulse pair 48 (generated during the time when pulse 41 impinged upon the second light source 33) are intra-period and have a well-defined phase difference $\varphi_0$. The two pulses of the pulse pair 49 (generated during the time when pulse 42 impinged upon the second light source 33) are intra-period and have a well-defined phase difference $\varphi_1$. The phase difference between the intra-period pulses of pulse pair 48 and 49 are different since the short current pulse was applied to the first light source during the generation (resulting also in the intensity change in portion 43). The phase difference between inter-period pulses (say the first pulse of pulse pair 48 and the first pulse of pulse pair 49) is random since the first light source is operated with a sufficiently long off period (or below threshold period), which is given by a difference of the pulse duration period and the pulse repletion period, i.e. $t_{long}$ - $t_{rep}$.

Graph 50 shows the intensity of the backward propagating light received by the intensity modulator 9 from the second light source 33. In graph 50, the (partial) reflection of pulses 41, 42 are indicated as reflected pulses 51, 52. As shown in graph 50, from time $t = t_{rt}$, the backward propagating pulse 51 impinges upon the intensity modulator for a period $t_{on}$. In the example of Figure 4, the optical device 32 is configured and operated such that the periods for the "on"-state, the "off"-state and the roundtrip time $t_{rt}$ are equal ($t_{on} = t_{off} = t_{rt}$). This means that the light reflected by the second light source 33 only impinges upon the intensity modulator 11 when the intensity modulator 11 is in the off-state. This means that the reflected light is blocked (or strongly attenuated) by the intensity modulator 11 and effectively prevented from propagating back to the first light source 7.

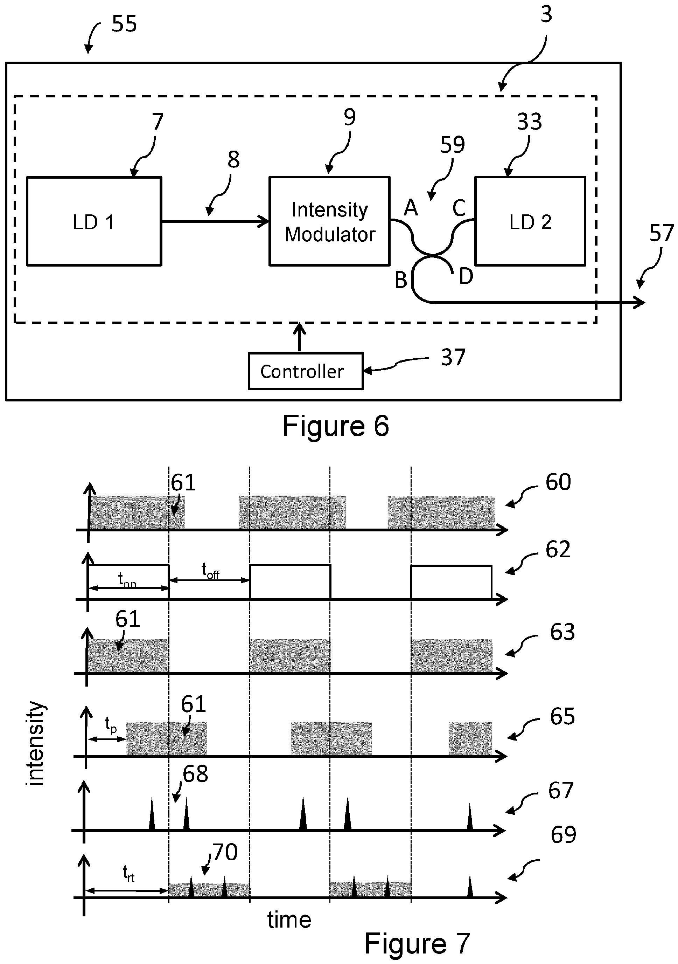

Figure 6 shows a variation on the optical device of Figure 4 (to avoid unnecessary repetition, like reference numerals will be used to denote like features). The optical device 55 comprises a PIC 3 and a controller 37. The PIC 3 comprises the first light source 7, the intensity modulator 9, and the second light source 33. The generation of long pulses by the first light source 7 and the transmission modulation by the intensity modulator 9 are as described with reference to Figure 4.

In the embodiment of Figure 6, the optical channel between the intensity modulator 9 and the second light source 33 comprises a beam splitter 59. The beam splitter 59 is integrated on the semiconductor substrate. The beam splitter 59 may have four ports A, B, C, D, as shown in Figure 6. Port A of the beam splitter 59 may be connected to the intensity modulator 9 (e.g. via a waveguide). Light entering Port A may be transmitted to ports C and D. The beam splitter 59 may be characterised by a beam splitter ratio. In an embodiment the beam splitter ration may be 50/50, i.e. for incoming light at port A (or B), 50% of the intensity exits the beam splitter 59 at port C and 50% of the intensity exits the beam splitter 59 at port D. In an alternative embodiment, the beam splitter ration may be 10/90, i.e. for incoming light at port A, 10% of the intensity exits the beam splitter 59 at port C and 90% of the intensity exits the beam splitter 59 at port D. In this case, for incoming light at port C, 10% of the intensity exits the beam splitter 59 at port A and 90% of the intensity exits the beam splitter 59 at port B).

Port C of the beam splitter 59 may be connected to the second light source 33. Thus, in the optical device 55, the second light source 33 receives the coherent light emitted by the first light source (and modulated by the intensity modulator 9) from port C of the beam splitter 59. The second light source 33 of the embodiment of Figure 6 is configured to generate short pulses as described with reference to Figure 4. However, the second light source 33 of the embodiment of Figure 6 is configured to output the generated pulses to the port C of the beam splitter 59 (instead to the output port 35 of Figure 4). Thus, short pulses generated by the second light source 33 are emitted propagating towards the first light source 7. The short pulses exit the beam splitter 59 depending on the beam splitter ratio at ports A and B. Port B may be connected to an optical output port 57. For example, the short pulses provided at the output port 57 may be submitted via an optical (quantum) channel to a receiver.

In an embodiment, port D of the beam splitter 59 may be connected to an integrated photo diode for monitoring the intensity of the pulses emitted by the first light source 7.

An example operation of the optical device 55 is described with reference to Figure 7. In this example, as in the example described with reference to Figure 5, the first light source 7 is operated to emit a number of long pulses. Graph 60 of Figure 7 illustrates the intensity of the long pulses emitted by the first light source 7 as received by the intensity modulator (but before the modulation is applied). In graph 60, an example pulse 61 is indicated. As described above, the intensity modulator 9 is periodically switched between the "on"- and "off"-state. Graph 62 shows a signal applied to the intensity modulator 9 to control its state. Initially, the intensity modulator 9 is set into the "on"-state for a period of time $t_{on}$. Then, the intensity modulator 9 is set into the "off"-state for a period of time $t_{off}$, before being switched back to the "on"-state for another period $t_{on}$ and so on. The first light source 7 and the intensity modulator 9 are synchronised in a way that a substantial portion of each of the long pulses is transmitted through the intensity modulator 9 during an "on" period. Graph 63 shows the intensity of the forward propagating light pulses after being modulated by the intensity modulator 9. In this example, duration $t_{long}$ of each of the long light pulses is longer than the "on" period of the intensity modulator 9.

Graph 46 of Figure 5 shows the intensity of the coherent light received by the second light source 33. As shown in graph 46, the long pulses 41, 42 arrive at the second light source 33 with a delay equal to the propagation time $t_p$, since this time is needed for the light to travel from the intensity modulator 9 to the second light source 33. For example, from time t = $t_p$, the example pulse 41 impinges upon the second light source 33 for a period $t_{on}$. During this time, a portion of the received light may be injected into the second light source 33 and may result in phase seeding of the second light source 33. Another portion of the received light may be reflected back towards port C of the beam splitter 59 (and thus towards the intensity modulator and the first light source 7). During the time that the long pulses (e.g. pulses 41, 42) are injected into the second light source 33, the controller 37 may apply a time varying current to the second light source 33 such that this gain-switched laser is switched above the lasing threshold twice, generating two short light pulses.

Graph 67 shows the short pulses emitted by the second light source 33. As described above with reference to Figure 5, the two pulses of the pulse pair 68 (generated during the time when pulse 61 impinged upon the second light source 33) are intra-period and have a well-defined phase difference. In contrast to the example of Figure 5, the short pulses shown in graph 67 of Figure 7 are emitted towards the port C of the beam splitter 59, i.e. the emitted short pulse are backwards propagating.

Graph 69 shows the intensity of the backward propagating light received by the intensity modulator 9 from port A of the beam splitter 59. Graph 69 also corresponds to the intensity at the output port 57 (up to a relative intensity factor given by the beam splitter ratio). The backward propagating light comprises a portion of the (partial) reflection of the long pulses and a portion of the short pulses. In graph 69, the (partial) reflection of pulses 61 is indicated as reflected pulse 70. In graph 69, the reflected long pulse and the emitted short pulses are shown with similar intensities for illustration purposes; it is understood that the intensity of the short pulses is typically orders of magnitude higher than the reflection. In the example of Figure 7, the optical device 55 is configured and operated such that the periods for the "on"-state, the "off"-state and the roundtrip time $t_{rt}$ are equal ($t_{on} = t_{off} = t_{rt}$). This means that the backward propagating light only impinges upon the intensity modulator 11 when the intensity modulator 11 is in the off-state. This means that the backward propagating light is blocked (or strongly attenuated) by the intensity modulator 11 and effectively prevented from propagating to the first light source 7. Thus, the optical device 55 allows to protect the first light source 7 from unwanted reflections of light emitted by the first light source 7 and from light emitted by the second light source 33. The optical device 55 can therefore prevent or suppress reciprocal seeding effects (i.e. strong perturbations of the first light source 7 caused by light emitted by the second light source 33) which are detrimental to the usefulness of the generated short pulses.

Whilst in the examples of Figures 2, 5, and 7 the "on" duration and the "off" duration are equally long ($t_{on}$ = $t_{off}$), it is understood that in other embodiments different switching timings may be used. In general, to block light reflected (or emitted) by the optical component 11 (or the second light 33) from propagating to the laser 7, the intensity modulator is held in the "off"-state during a time when this light is expected to impinge upon the modulator 9. This time starts at a point in time which is the roundtrip time apart from (i.e. later than) the time when the pulse starts exiting the modulator 9 in the "on"-state. For some applications, it may be sufficient to block only a leading portion of the reflected pulse instead of the entire reflected pulse. Thus, in some embodiments the "off"-period may be shorter than the duration of the reflected pulse (or the pulse emitted by the second light 33).

Whilst the embodiments of the optical device of Figures 1, 3 and 5 comprise components integrated on a photonic integrated circuit, a variation of the optical device may not employ (full) photonic integration. In such an embodiment, at least one of the light source 7, the intensity modulator 9 and the optical component 11 is provided off-chip (i.e. not as a component integrated on a PIC).

Whilst certain embodiments have been described, these embodiments have been presented by way of example only, and are not intended to limit the scope of the inventions. Indeed, the novel devices, and methods described herein may be embodied in a variety of other forms; furthermore, various omissions, substitutions and changes in the form of the devices, methods and products described herein may be made without departing from the spirit of the inventions. The accompanying claims and their equivalents are intended to cover such forms or modifications as would fall within the scope and spirit of the inventions.

**Claims**

1. An optical device, the device comprising:

   a light source;
   an intensity control element being adjustable between an on-state and an off-state;
   an optical channel comprising a first and a second port, the optical channel being **characterised by** an optical propagation time from the first to the second port; and
   an optical component,

   wherein the light source is configured to supply an optical pulse to the intensity control element, the intensity control element is configured to modulate an intensity of the received optical pulse and to provide the modulated pulse to the first port of the optical channel, an intensity of the modulated optical pulse being higher when the intensity control element is in the on-state than in the off-state, and the optical component is configured to receive the modulated optical pulse from the second port of the channel,
   and wherein the optical intensity modulator is configured such that at least a portion of the optical pulse is modulated in the on-state, the leading edge of said portion exits the optical intensity modulator at a first time, and the optical intensity modulator is in the off-state at a second time which is twice the optical propagation time measured from the first time.

2. The optical device of claim 1, the device further comprising a semiconductor substrate, and wherein the light source, the intensity control element, the optical channel and the optical component are integrated on the semiconductor substrate,
   and/or wherein the intensity of the modulated optical pulse is at least twice as high when the intensity control element is in the on-state than in the off-state.

3. The optical device of claim 1 or 2, wherein the on-state is held for a first duration, the first duration being equal to or shorter than twice the propagation time through the optical channel,

   and optionally wherein the off-state is held for a second duration being equal or longer than twice the propagation time through the optical channel,
   and further optionally wherein the second duration is equal to the first duration, and the first duration is equal to twice the propagation time through the optical channel.

4. The optical device of claim 3, wherein the optical pulse has a pulse duration which is longer than the first duration.

5. The optical device of any preceding claim, wherein the device further comprises:

   a light source controller configured to control to the light source, and
   an intensity control element controller configured to control the intensity control element to switch the intensity control element between the on-state and the off-state.

6. The optical device of claim 5, wherein the device is further configured to receive information specifying the first and second durations, and the intensity control element controller is further configured to hold and switch the state of the intensity control element based on the received information.

7. The optical device of any preceding claim, wherein the optical component is at least partially reflective.

8. The optical device of any preceding claim, wherein the optical component is an optical grating, a multimode interferometer, a mirror, a scattering element, or a photonic nanostructure.

9. The optical device of any preceding claim, wherein the light source is configured to supply coherent light to the intensity control element,

   and optionally wherein the light source is configured to supply light pulses to the intensity control element with a pulse repetition period equal to a sum of the first duration and a second duration, and wherein, for each pulse, the on-state is held for the first duration and the off-state is held for the second period,
   and further optionally wherein a phase difference between consecutive pulses is random.

10. The optical device of claim 9, wherein the light source is a first light source, and the optical component is a second light source configured to produce optical amplification, and wherein the device further comprises a second light source controller configured to apply a time varying signal to the second light source such that a plurality of light pulses, having a fixed phase relation, are emitted from the second light source during a period of time that coherent light transmitted through the intensity control element during the first duration is received,

    and optionally wherein the device further comprises an encoder configured to encode information in an emission time of the plurality of light pulses emitted from the second light source during a period of time that coherent light transmitted through the intensity control element during the first period of time is received,
    or wherein the device further comprises an encoder configured to encode information in a phase difference between the plurality of light pulses emitted from the second light source during a period of time that coherent light transmitted through the intensity control element during the first duration is received.

11. The optical device of claim 10, wherein the second light source comprises at least one of an optical gain medium, a laser cavity and an optical resonator.

12. The optical device of any preceding claim, wherein the intensity control element comprises at least one of an electro-absorption modulator, a Mach-Zehnder modulator, a semiconductor optical amplifier or an optical switch.

13. The optical device of any one of claims 10 to 12, wherein the first light source comprises a semiconductor laser diode,
    and optionally wherein the semiconductor laser diode is a distributed feedback laser, a stripe laser, or a vertical cavity surface emitting laser.

14. The optical device of any one of claims 10 to 13, wherein the optical channel comprises a beam splitter, and wherein the beam splitter is configured to receive, at a first port of the beam splitter, the coherent light transmitted through the intensity control element and provide, at a second port of the beam splitter, at least a portion of the received coherent light to the second light source; the second light source is configured to receive, from the second port of the beam splitter, the at least portion of the coherent light and to provide the plurality of generated light pulses to the second port of the beam splitter; and the optical device further comprises an output port configured to provide, as output, at least a portion of the plurality of generated light pulses received from a third port of the beam splitter.

15. A transmitter for a quantum communication system, comprising the optical device of any one of claims 10 to 14.

Figure 1

Figure 2

FIG. 3A

FIG. 3B

FIG. 3C

FIG. 3D

Figure 4

Figure 5

Figure 6

Figure 7

Europäisches
Patentamt

European
Patent Office

Office européen
des brevets

# EUROPEAN SEARCH REPORT

Application Number

EP 23 21 9598

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/237779 A1 (SUZUKI YUICHI [JP] ET AL) 24 September 2009 (2009-09-24) * paragraph [0054] - paragraph [0067]; figures 1,2 * ----- | 1-15 | INV. H04B10/54 H04B10/70 H01S5/00 H01S5/0625 |
| X | US 2005/213618 A1 (SOCHAVA SERGEI L [US] ET AL) 29 September 2005 (2005-09-29) * paragraph [0062]; figures 3d, 3e, 4d, 4e * ----- | 1-15 | |
| X | US 2015/304051 A1 (YUAN ZHILIANG [GB] ET AL) 22 October 2015 (2015-10-22) * paragraph [0291] - paragraph [0292]; figure 4b * * paragraph [0318] - paragraph [0320] * ----- | 1-15 | |

TECHNICAL FIELDS
SEARCHED      (IPC)

H04B
H01S

The present search report has been drawn up for all claims

| Place of search | Date of completion of the search | Examiner |
|---|---|---|
| Munich | 10 May 2024 | Gäde, Sebastian |

## ANNEX TO THE EUROPEAN SEARCH REPORT
## ON EUROPEAN PATENT APPLICATION NO.

EP 23 21 9598

This annex lists the patent family members relating to the patent documents cited in the above-mentioned European search report.
The members are as contained in the European Patent Office EDP file on
The European Patent Office is in no way liable for these particulars which are merely given for the purpose of information.

10-05-2024

| Patent document cited in search report | | Publication date | Patent family member(s) | | Publication date |
|---|---|---|---|---|---|
| US 2009237779 | A1 | 24-09-2009 | JP | 5119998 B2 | 16-01-2013 |
| | | | JP | 2009223079 A | 01-10-2009 |
| | | | US | 2009237779 A1 | 24-09-2009 |
| US 2005213618 | A1 | 29-09-2005 | CN | 1930748 A | 14-03-2007 |
| | | | US | 2005213618 A1 | 29-09-2005 |
| | | | WO | 2005101595 A1 | 27-10-2005 |
| US 2015304051 | A1 | 22-10-2015 | NONE | | |

EPO FORM P0459

For more details about this annex : see Official Journal of the European Patent Office, No. 12/82